# EUROPEAN PATENT SPECIFICATION

(11) **EP 0 801 810 B1**
(45) Date of publication and mention of the grant of the patent: **14.09.2005**
(21) Application number: 95942797.2
(22) Date of filing: 28.12.1995
(51) Int. Cl.: H01J 37/20

(54) **SPECIMEN HOLDER FOR AN ELECTRON MICROSCOPE AND DEVICE AND METHOD FOR MOUNTING A SPECIMEN IN AN ELECTRON MICROSCOPE**
PROBENHALTER FUER EIN ELEKTRONENMIKROSKOP UND VORRICHTUNG UND VERFAHREN ZUM MONTIEREN EINER PROBE IN EINEM ELEKTRONENMIKROSKOP
PORTE-PRELEVEMENT POUR MICROSCOPE ELECTRONIQUE, ET DISPOSITIF ET PROCEDE DESTINES A PLACER UN PRELEVEMENT DANS UN MICROSCOPE ELECTRONIQUE

(30) Priority: 28.12.1994 NL 9402226; 30.12.1994 NL 9402241
(43) Date of publication of application: 22.10.1997
(73) Proprietor: Technische Universiteit Delft, 2628 BL Delft (NL); STICHTING SCHEIKUNDIG ONDERZOEK IN NEDERLAND (SON), 2509 AC Den Haag (NL); Stichting voor de Technische Wetenschappen, 3527 JP Utrecht (NL)
(72) Inventor: ZANDBERGEN, Hendrik, Willem, NL-2628 BL Delft (NL); LATENSTEIN VAN VOORST, André, 5612 HH Eindhoven (NL); WESTRA, Cornelis, 3312 EH Dordrecht (NL); HOVELING, Gerardus, Hendrikus, NL-2628 BL Delft (NL)
(74) Representative: Smulders, Theodorus A.H.J.
(86) International application number: PCT/NL1995/000444
(87) International publication number: WO 1996/020495

(56) References cited:
- EP-A- 0 196 252
- EP-A- 0 504 972
- WO-A-83/03707
- GB-A- 2 027 930
- US-A- 4 797 261
- US-A- 5 225 683
- US-A- 5 326 971

## Description

The invention relates to a device for mounting a specimen in an electron microscope, according to the preamble of claim 1. Such device is known from EP 0,504,972.

This known device comprises a specimen holder, provided with a carrier connected to the specimen receiving means of the holder. The carrier is provided within a tip which is detachable from the specimen holder. The carrier is connected to a shaft. The carrier can be tilted about said shaft by means of a push rod and a tilting member. In this known device the tip has to be disconnected from the specimen holder in order to place a specimen in said carrier or to remove said specimen therefrom. The tip has a relatively large distance between said shaft and the attachment means for attachment of the tip to the further rod-shaped member of the specimen holder.

In some cases, for the purpose of protection, it is required for the specimen to be introduced into and held in the specimen holder and the electron microscope in an airtight and moisture-proof condition. When replacing a specimen by another specimen, the specimen holder must then be retracted, with the specimen having to be screened off. Then, in a special device, the specimen must be removed from the specimen holder and another specimen must be arranged, whereafter the specimen is screened off again and the specimen holder is placed back into the electron microscope. In particular when specimens are replaced frequently, this involves a great risk of damage to the specimens. Another disadvantage is that such specimens are not easily manipulable in high vacuum.

The object of the invention is to provide a device of the type described in the opening paragraph hereof, whereby the above-mentioned disadvantages are avoided. To that end, a device according to the present invention is characterized by the features of claim 1.

A specimen can be locked in the specimen carrier, whereafter the specimen carrier with the specimen can be moved into and out of the specimen-receiving means in the specimen holder. The specimen itself no longer needs to be engaged once it has been placed in the specimen carrier. This provides the important advantage that the delicate specimen is not damaged even upon repeated movement into and out of the specimen holder and moreover is easy to handle. Because the specimen carrier is manipulable with simple means without great risk of damage to the specimen, it is easy to work under high vacuum using, for instance, a robot arm or a different type of manipulator. The specimen carrier adequately provides support and protection for the specimen. A further advantage is that the specimens can be placed and removed faster and can be positioned in a simpler manner. In addition, specimen carriers with different preparations can always be mounted in the same manner. Further, storing the specimens by accommodating them in a specimen carrier is facilitated, certainly when the specimens remain locked in the specimen carrier. Furthermore, a specimen can be placed in the specimen carrier when the specimen is still firm, whereafter it can be thinned in the specimen carrier. In the thinned phase, the specimen is very fragile but need not be engaged anymore, because it is accommodated in the specimen carrier. Since the specimen receiving means are removably fixed directly into the bore in the specimen carrier, movement thereof is prevented, providing for a steady view during use without further measures. When removed from said bore the carrier is readily accessible for introduction or removal of the specimen.

The specimen carrier is preferably made of molybdenum film or like sheet or film material.

In further elaboration, the device according to the invention is characterized by the features according to claims 5-7.

The specimen carrier can be simply clamped against the shoulder in the bore by means of the threaded ring, so that the position of the specimen carrier is uniformly defined. Moreover, there is no risk of the specimen being damaged as it is being clamped, the less so when such clamping is effected by means of the operating arm. Because for the purpose of fixing or releasing the specimen carrier the threaded ring need only be turned through an angle of less than 360°, for instance 90° or less, the specimen carriers can be exchanged rapidly and safely. Since the specimen carrier can be slid between the shoulder and the threaded ring from one side, the threaded ring need not be removed completely for the purpose of replacing the specimen carrier, so that the specimen carrier can be replaced even faster and moreover there is no risk of the threaded ring falling from the specimen holder and possibly being lost. This is of importance in particular when specimen carriers have to be exchanged or otherwise manipulated within the electron microscope or in a different closed and optionally conditioned space.

By placing a series of specimen carriers in a conditioned space of an electron microscope, with the specimen carriers each containing a specimen, the specimens can be exchanged without the specimen holder having to be removed from the electron microscope. This prevents the necessity of having to re-condition the space every time the specimens are exchanged or having to take special measures to prevent the conditioned space from being affected during the exchanges. The specimens that are to be analyzed during one or a number of sessions can be arranged simultaneously in the space, whereafter they can be mutually exchanged by means of the manipulation means. In addition, as a result, a considerably time gain is achieved and the specimen holder need not be removed from the electron microscope. This eliminates the necessity of thermally equilibrating the specimen holder with the specimen carrier exchanged outside the electron microscope.

The invention as defined in Claim 10 further relates to a specimen carrier suitable for use in a device according to the invention.

Furthermore a specimen holder for an electron microscope is disclosed but not claimed. A specimen holder is known from practice and is marketed, for instance, by Gatan Incorporated, Pleasanton, USA.

In the known specimen holder, the bar-shaped body is slidably mounted within a thin tube. In the first position, the bar-shaped body is completely withdrawn within the tube while being carried adjacent its free end by an elastic 0-ring included with a proper fit between the bar-shaped body and the inside of the tube. Remote therefrom, the bar-shaped body is connected with the tube by means of bellows. In this position, the specimen is confined between the 0-ring, the bellows and the tube, and screened from the environment.

In the second position, the bar-shaped body is slid partly out of the tube, in such a manner that at least the specimen is situated outside the tube. In this position, the bar-shaped body is carried by the 0-ring and the bellows. In many cases, during use this provides insufficient stability for the specimen in the electron microscope, to the extent that a preparation or specimen to be examined, after being set, may be undesirably moved during the examination, for instance vibrated, owing to the deforming properties of the elastic ring. Moreover, in this known specimen holder, the extent of stability of the specimen is dependent to a considerable degree on the extent to which the bar-shaped body is slid out of the thin tube.

A device according to the invention as defined in Claim 1 is equipped with a specimen holder of the type described in the opening paragraph, whereby the disadvantages mentioned are avoided.
By virtue of the feature that at least in the second position, that is, the position wherein the specimen can be viewed under the electron microscope, the bar-shaped body, and hence the specimen, is supported directly by the supporting means, movement of the specimen during the examination, that is, after the specimen holder has been set, is prevented. In the device according to the invention, the elastic seal has no bearing function but only a sealing function. As a result, the sealing of the specimen in the first position can be ensured better and moreover direct contact between the bar-shaped body and the supporting means in the second position is ensured. The extent to which the screening means and the bar-shaped body are moved relative to each other between the first and the second position has no influence, at least after setting, on the extent of movement of the specimen, since the support of the specimen is direct and always at the same position relative to the supporting means, which can be supported in the electron microscope, for instance in a goniometer.

In an advantageous embodiment, the device as claimed is characterized such that in the first position the specimen is screened from the environment by a shell-shaped element and two elastic seals, such as for instance 0-rings, while in the second position too the two elastic seals are screened substantially completely from the environment by the shell-shaped element. This prevents contamination and any damage and dislocation of the seals, so that a proper operation of the device is ensured at all times.

The bar-shaped body is preferably fixedly connected with the supporting means. Thus the position of a specimen received in the specimen-receiving means is fixed uniformly and unchangeably. In addition, movement of the bar-shaped body relative to the supporting means is impossible. The screening means comprise a sleeve which is movable along the bar-shaped body between the first and the second position. These movements have no influence on the position of the specimen.

Alternatively the bar-shaped body, at least in the second position, is supported at least on two sides of the specimen-receiving means. By virtue of the feature that in the second position the free end of the bar-shaped body is at least partly received with a proper fit in a cavity in the tubular body, a direct coupling between them is obtained. Moreover, in the second position, the position of the specimen-receiving means is fixed by the opening. In the first position, the specimen is suitably screened by the tubular body and the elastic seal.

During the use of the device, in the service position of the specimen holder, that is, with the specimen-receiving means in the second position, the bar-shaped body can be fixedly connected with the tubular body by the coupling means. The coupling means are capable of being linked with such a fit that movement of the two bodies relative to each other is no longer possible, with the exception of a movement back to the first, screened position. The coupling means thus prevent movement of the specimen in the second position during use of the specimen holder within an electron microscope.

The coupling means may, for instance, be formed by coacting pins and holes, a conic ring on the bar-shaped body receivable with a proper fit in an opening in the tubular body or like connecting elements fitting into or over each other.

In further elaboration, a pivoting receiving body capable of carrying the specimen is provided, offering the advantage that the specimen can be changed in position within the specimen holder, in such a manner that it can be viewed in different positions. By virtue of the feature that upon displacement of the screening means relative to the specimen-receiving means the tilting means move the pivoting body, the position of the specimen can be simply adjusted by means of the screening means. This embodiment provides the advantage that the specimen holder can be made of simple and relatively robust design, while yet the specimen can be viewed from practically all sides, since no additional operating means need to be provided which extend in or along the specimen holder for control of the tilting movement of the pivoting body. The movements of the pivoting body are limited by the pole shoes of the electron microscope.

Further a method is disclosed but not claimed for mounting a specimen in an electron microscope in a position suitable for examination, wherein the specimen is received in a specimen holder in a specimen-receiving means adjacent an end of a bar-shaped body, with the specimen being screened from the environment in a first position of the specimen holder by screening means comprising at least one elastic seal included between the bar-shaped body and a screening shell, while at least the end of the bar-shaped body with the specimen is moved inside the electron microscope, and the screening means and the bar-shaped body are moved relative to each other into a second position wherein the specimen is cleared for examination within the electron microscope, with the specimen holder being arranged in the electron microscope by means of supporting means. In this method the bar-shaped body in the second position is supported directly on the supporting means, without intermediacy of the elastic seal, in such a manner that movements of the bar-shaped body, and hence the specimen, relative to the supporting means and the electron microscope are prevented.

By the use of such method an optimally stable, suitable and reproducible positioning of a specimen within an electron microscope is enabled in a particularly simple and uniform manner.

For the analysis of a specimen in an electron microscope, usually a specimen which is formed by a small and thin slice of material is mounted in a specimen holder and then introduced into an electron microscope. To that end, the specimen holder is provided with a bore in which the specimen can be placed on a shoulder and be clamped, for instance with a locking ring.

The specimen carrier can be simply clamped against the shoulder in the bore by means of the threaded ring, so that the position of the specimen carrier is uniformly defined. Moreover, there is no risk of the specimen being damaged as it is being clamped, the less so when such clamping is effected by means of the operating arm. Because for the purpose of fixing or releasing the specimen carrier the threaded ring need only be turned through an angle of less than 360°, for instance 90° or less, the specimen carriers can be exchanged rapidly and safely. Since the specimen carrier can be slid between the shoulder and the threaded ring from one side, the threaded ring need not be removed completely for the purpose of replacing the specimen carrier, so that the specimen carrier can be replaced even faster and moreover there is no risk of the threaded ring falling from the specimen holder and possibly being lost. This is of importance in particular when specimen carriers have to be exchanged or otherwise manipulated within the electron microscope or in a different closed and optionally conditioned space.

To clarify the invention as claimed, a number of exemplary examples of a specimen holder will be described with reference to the drawings, wherein:
Fig. 1 is a partial cross section and top plan view of a first example not being an embodiment of a specimen holder;
Fig. 2a is a partial cross section and top plan view of a second example not being an embodiment of a specimen holder;
Fig. 2b is a partial cross section and side elevation of a second example not being an embodiment of a specimen holder;
Fig. 3 is a cross section of a specimen holder in a third example not being an embodiment;
Figs. 4a and 4b are partly cutaway side elevations of a specimen holder in a fourth example not being an embodiment in the first and the second position, respectively;
Fig. 4c is a cross section of the specimen holder according to Figs. 4a and 4b;
Fig. 5 is a cross section of a specimen holder in a fifth example not being an embodiment;
Fig. 6 is a cross section of a part of a specimen holder according to Figs. 1, 2 or 3, with a first embodiment of the specimen-receiving means, on a larger scale;
Fig. 7 is a specimen carrier in opened condition, together with a specimen to be received therein;
Fig. 8 shows the specimen carrier according to Fig. 7 in closed condition, with the specimen received therein;
Fig. 9 shows a part of a specimen holder with a specimen carrier received in manipulation means; and
Fig. 10 is a diagrammatic top plan view of a space of or on an electron microscope having therein a series of specimen carriers, a specimen holder and means for manipulating at least the specimen carriers. Fig. 1 to 6 show examples not being embodiments of specimen holders for use in a device according to the present invention or with a specimen carrier according to the present invention, as for example shown in fig. 7 and 8.

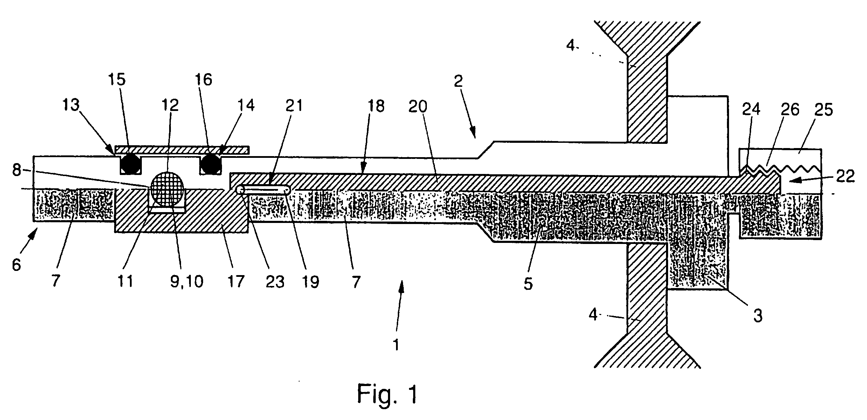

Fig. 1 shows in sectioned top plan view a specimen holder 1 which specimen holder comprises a bar-shaped body 2 which, adjacent one end, is provided with a foot 3 for conventional fixed arrangement of the specimen holder 1 adjacent to and partly in an electron microscope, of which only a portion 4 is shown. For that purpose, the electron microscope may be provided with a goniometer and/or other supporting points. The bar-shaped body 2 comprises a bar element 5 which is fixedly connected with the foot 3. The bar element 5 is thinner than the foot 3 and the free end 6 of the bar element 5 is formed by a reduced portion 7 which is at least receivable in the electron microscope.

The reduced portion 7, at some distance from the free end 6 thereof, is provided with a first bore 8, being a through bore, which extends substantially transversely to the longitudinal direction of the bar element 5. Included within the first bore 8 are means 9 for bearing and fixing a specimen 10 which is to be viewed by the electron microscope. These means 9 may, for instance, comprise a bearing edge 11 and a clamping ring 12, but can be designed in a different, known and suitable manner.

On the side of the first bore 8 proximal to the free end 6 of the reduced portion 7, the reduced portion 7 is provided, adjacent the bore 8, with a first circular groove 13. On the other side of the first bore 8 the reduced portion 7 is provided with a second circular groove 14. Received in the grooves 13, 14 are a first 15 and a second elastic seal 16, respectively, for instance in the form of a rubber or plastic O-ring. Each seal 15, 16 projects slightly outside the reduced portion 7. Slid around the reduced portion 7 is a shell-shaped element in the form of a shell-shaped screen 17 which has a length at least corresponding with the distance between the sides of the two O-rings 15, 16 facing away from each other. The inner diameter of the screen 17 is slightly less than the outer diameter of the O-rings 15, 16. The screen 17 can be slid over the O-rings 15, 16, whereby the O-rings are compressed to some extent, such that the outside thereof abuts against the inside of the screen 17 under a bias. In this first position, which is shown in Fig. 1, the seals 15, 16 and the screen 17 constitute an airtight and moisture-proof shield from the environment for the bore 8 and any specimen 10 received therein.

A second bore 18 extends through the foot 3 and the bar element 5 in the longitudinal direction of the bar-shaped body 2, up to a point close to the side of the second O-ring 16 proximal to the housing portion 4. Provided in the reduced portion 7 is a slotted opening 19 which continues into the second bore 18. Extending through the second bore 18 is a rod 20 which is slidable within the second bore 18. The first end 21 of the rod 20 is located under the opening 19, the second end 22 projects beyond the side of the foot 3 remote from the bar element 5.

The first end 21 of the rod 20 is connected to the screen 17 via a connecting pin 23 which extends through the opening 19, such that the rod 20 and the screen 17 cannot rotate relative to the bar element 5. The second end 22 of the rod 20 is provided with external screw thread 24, on which is fitted an adjusting knob 25 provided with internal screw thread. The adjusting knob 25 has one side abutting against the foot 3 and cannot shift relative to the foot 3. Since the rod 20 cannot rotate relative to the screen 17 or the bar element 5, rotation of the adjusting knob 25 causes the screen 17 to move in longitudinal direction relative to the reduced portion 7 and hence relative to the seals 15, 16 and the specimen-receiving means 9.

The specimen holder 1 can be used as follows.

A specimen 10 is fixed in the bore 8 by means of the specimen-receiving means 9; 11, 12, in a space suitable therefor, which is preferably closed and conditioned. Then the adjusting knob 25 is rotated such that the screen 17 is slid over the two seals 15, 16, so that the specimen is screened in airtight and moisture-proof manner from its environment by means of those seals 15, 16 and the screen 17. Then the specimen holder 1 can be picked up and further manipulated without any risk of contamination of the specimen. By means of the foot 3 the specimen holder is arranged adjacent an electron microscope, such that at least the reduced portion 7 extends within the part of the microscope appropriate therefor. Because the bore 8 is located at a fixed distance from the foot 3, placement of the specimen holder in the suitable position is simply realizable. To that end, for instance positioning points or like means can be arranged at the proper points outside the microscope. After placement, the adjusting knob 25 is turned back to such an extent that the screen 17, by means of the rod 20, is shifted back along the reduced portion in the direction of the foot 3, at least so far that the specimen is cleared for inspection. The second seal 16 remains covered by the screen. As a result, shifting the screen remains possible in a simple manner and moreover contamination of at least the second seal 16 and in particular the specimen is prevented.

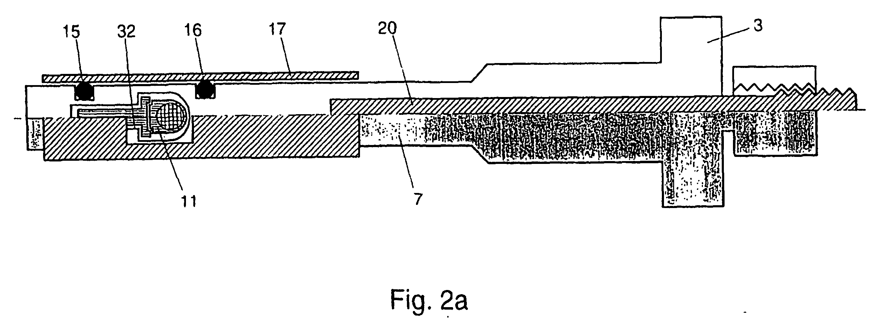

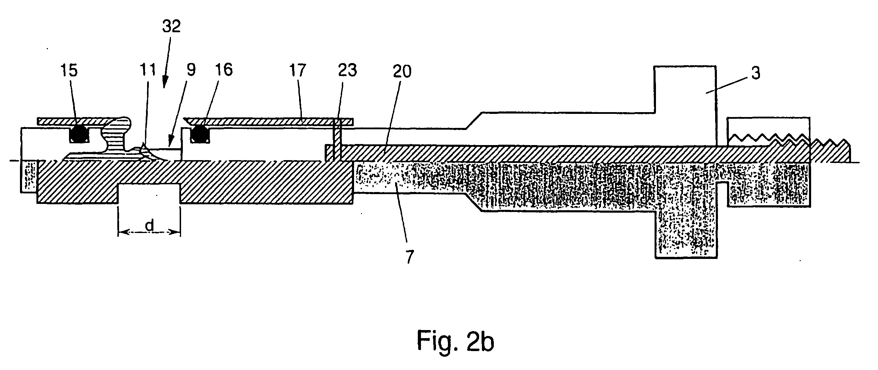

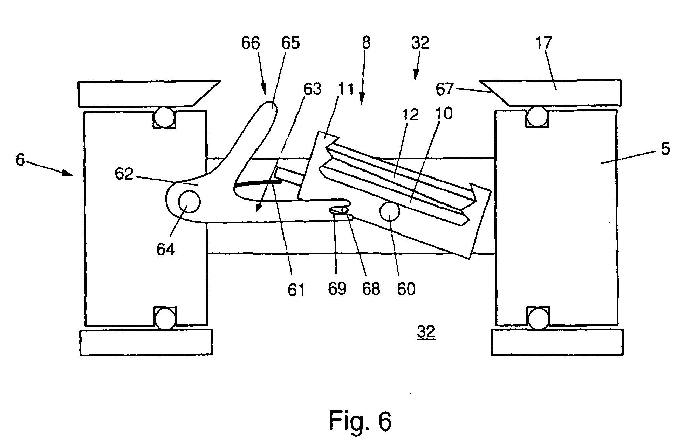

According to a second particular example not being an embodiment (Figs. 2a, 2b), adjacent one of the ends of the screen 17 an opening is provided above and under the bar-shaped element, through which the specimen can be viewed in the second position. The screen 17 has a length at least equal to the distance between the first 15 and the second seal 16 plus the width d of the opening 32. The advantage of this example not being an embodiment is that the two seals are always covered by the screen 17, at least in the first and second positions. In addition, this example not being an embodiment comprises a tilting mechanism for the specimen, operable by the screen 17, which will be described in more detail below with reference to Fig. 6.

In the service position, wherein the specimen holder extends partly within the electron microscope and the screen 17 around the specimen 10 has been moved away into the second position, the bar-shaped element 5 and the foot 3 are borne directly by the microscope 4. None of these parts is so flexible as to involve the risk of their causing an unacceptable vibration of the specimen-receiving means 9; 11, 12, during the study of the specimen 10. Thus the specimen is carried in a highly stable manner, so that a good stable image can be obtained with the electron microscope 4.

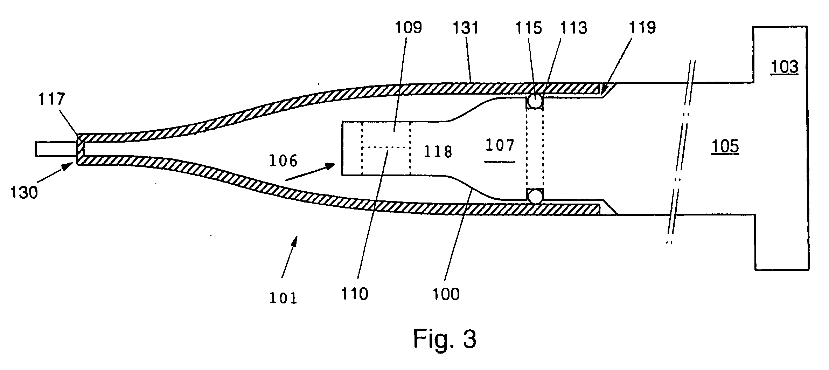

Fig. 3 shows a third example not being an embodiment, which comprises a foot 103 and a bar-shaped in the form of a bar element 105 which extends from the foot 103. Included adjacent the free end 106 of the bar element 105 are specimen-receiving means 109. Provided in the bar element on the side of the specimen-receiving means remote from the free end 106 is a circular recess 113 accommodating an elastically deformable seal 115, preferably in the form of a rubber or plastic ring. The ring extends slightly outside the surface of the bar element. In a first position, as depicted in Fig. 3, a cap-shaped screen 117 is slid over the free end 106 and over the seal 115, in such a manner that the seal is slightly compressed and abuts the inside of the screen 117 under tension and with a proper fit along the entire outer circumference.

The screen 117 has a closed end wall 130 and a substantially closed circumferential wall 131. In the first position, a specimen, if any, received in the specimen-receiving means 109 is screened off from its environment in a completely airtight and moisture-proof manner by the screen 117 and the seal 115. The cap-shaped screen 117 has a circular opening 119 located on the side opposite the end wall 130. Adjacent the end wall 130 the cap-shaped screen 117 is flattened so as to fit over the reduced portion 107 but between the pole shoes of the electron microscope. When pulling away the screen, it should be pulled between the pole shoes. To that end, the screen is made of elastically deformable design, in such a manner that the circular opening can be squeezed to a height less than the distance between the pole shoes, and after removal of the deforming force it springs back to substantially resume its original shape.

The part 118 of the reduced portion 107, extending between the seal 115 and the specimen-receiving means 109, tapers in the direction of the free end 106. As a result, when re-placing the screen 117, the opening 119, deformed to an approximately oval shape upon removal, is pressed back into the circular shape, so that again a good screening of the specimen can be obtained by means of the screen 117 and the seal 115.

This specimen holder 101 can be used as follows.

The screen 117 is pulled completely off the bar element 105 in the direction of the free end 106, whereafter a specimen 110 can be arranged in the specimen-receiving means 109, preferably under conditioned circumstances. Then the screen is slid into the first position over the bar element 105 and so the specimen is properly protected. After placement of the specimen holder 101 in the desired position adjacent (and in) the electron microscope, the screen 117 is pulled away again, so that the specimen 110 can be viewed with the electron microscope.

In this example not being an embodiment, too, means may be included within the specimen holder for moving the screen from the first to the second position *vice versa,* but the cap-shaped screen 117 can also be operated with an external manipulator, and this also applies to the other examples not being embodiments shown. In this example not being an embodiment, adjacent the free end 106 a reduced portion 107 is included, along which the screen is slidable, with the outer circumference of the screen 117 being approximately equal to the outer circumference of the non-reduced portion of the bar element 105. As a consequence, the reduced portion 107 together with the screen 117 can be introduced, for instance by means of a goniometer, into the electron microscope, which can connect with a proper fit to the outer circumference of the bar element 105. In addition, the non-reduced portion 105 provides greater strength and rigidity, while the relatively short reduced portion 107 can be made of thin design to be received in a relevant part of the microscope.

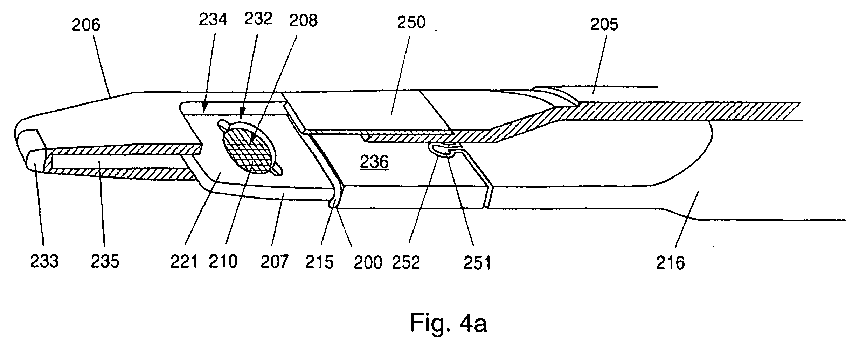

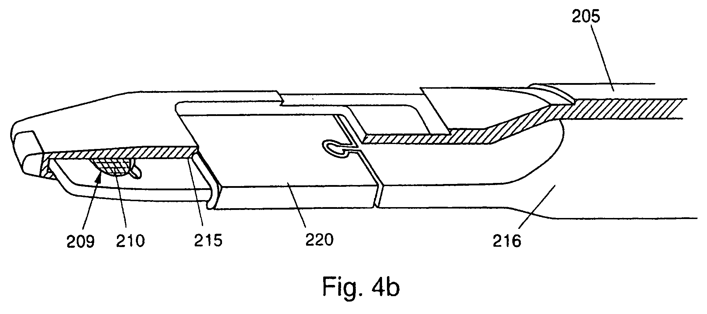

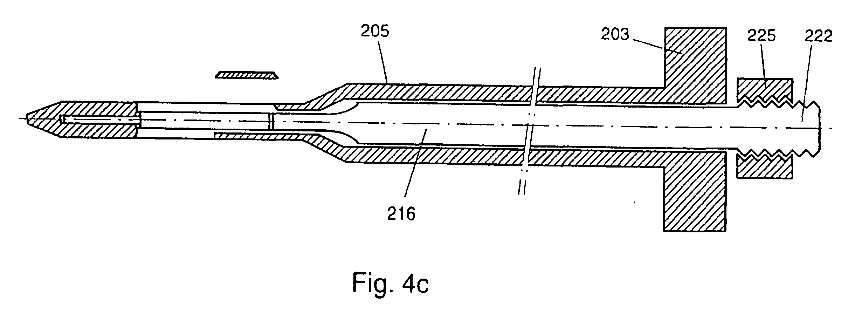

Figs. 4a, 4b, and 4c show a fourth example not being an embodiment of the specimen holder 201, wherein the specimen-receiving means 209 are included in a drawer-shaped element 220. This example not being an embodiment again comprises a foot 203 (not shown) and a tubular bar element 205 extending therefrom, in which a rod-shaped element 216 is slidably mounted. Provided at the free end of the rod-shaped element 216 is a knob 251 with a round head. To the free end of the rod-shaped element 216 connects a drawer 220 provided with a recess 252 in which the knob 251 is accommodated, surrounded by space. The drawer 220 is thus coupled to the rod-shaped element 216, in such a manner that it can be moved by it, while in a central position the knob 251 is clear of the recess 252 on all sides and then no forces can be transmitted between the drawer 220 and the rod-shaped element 216 *vice versa.* The tubular bar element 205 comprises adjacent the free end 206 a continuous, for instance slotted, opening 232, and has a closed end 233. The first end 221 of the drawer 220 comprises a portion 207 flattened at the top and the bottom 236, in which a bore 208 is provided which extends substantially transversely to the longitudinal direction of the bar element 205. Arranged in or adjacent the bore 208 are the specimen-receiving means. The second end of the rod-shaped element 216, on the side remote from the bar element 205, extends outside the housing portion and there comprises an adjusting knob 225 in the manner described above.

On opposite sides, the drawer 220 is mounted with a sliding fit in longitudinal guides 234 in the tubular bar element, and the first end 221 of the drawer 220 is mounted with a sliding fit in a cavity 235 in the portion of the bar element 205 located adjacent the free end 206. Included in one of the longitudinal guides 234 is a resilient element which presses the drawer 220 against the opposite longitudinal guide to prevent undesired movement. The drawer 220 can only slide in the longitudinal direction, cannot rotate and cannot move up and down or laterally, transversely to the longitudinal direction. The depth of the cavity 235 is such that the first end 221 of the drawer 220 with the bore 208 can be received therein.

The shoulder 200 formed by the transition to the flattened portion 207 of the drawer is spaced from the free end of the drawer by a distance approximately corresponding with the depth of the cavity 235. Arranged against the shoulder 200, around the flattened portion 207, is a seal 215, preferably in the form of a rubber or plastic ring abutting the drawer under a bias. When the drawer 220 is slid into the cavity 235 to a maximum extent, the seal 215 seals the opening 232 of the cavity 235 completely.

This example not being an embodiment of a specimen holder can be used as follows. (Fig. 4a shows the first position; Figs. 4b and 4c the second).

A specimen 210 is received in the specimen-receiving means 209, preferably in a conditioned environment, whereafter the drawer 220 is slid into the cavity 235 by means of the adjusting knob 225. In that second position, the specimen is locked between the seal 215 and the cavity 235 of the bar element 205. As a result, the specimen is closed off from its environment at least in airtight and moisture-proof manner. After the specimen holder 201 has been mounted in a microscope in the manner described above, the drawer 220 is retracted by means of the adjusting knob 225 into the first position, wherein the bore 208, and hence the specimen 210, extends at the location of the opening 232. During displacement, the flattened portion 207 is guided by the longitudinal guides 234. As a result, the specimen 210 is cleared for inspection, while the fit of the flattened portion 207 in the longitudinal guides 234, together with the part of the drawer 220 slidably fitting within the bar element 205, provides for a motion-free, in particular vibration-free, arrangement of the specimen 210. By turning the adjusting knob back slightly, the knob 251 in the recess 252 is brought into the central position, so that the rod-shaped element 216 is uncoupled from the drawer 220. Thus no forces can be transmitted between the two. Because the seal 215 is covered both in the first and in the second position, the seal is prevented from becoming soiled in a simple manner.

At the top, the flattened portion 207 comprises a cover 250, which can be moved laterally, that is, transversely to the longitudinal direction, this cover 250 covering at least a part of the drawer 220. The cover 250 connects to the opening 232 and forms the longitudinal edge of the opening 232 on the side proximal to the housing portion 204. By removing this cover 250, the drawer 220 can be more easily removed, for instance for repair.

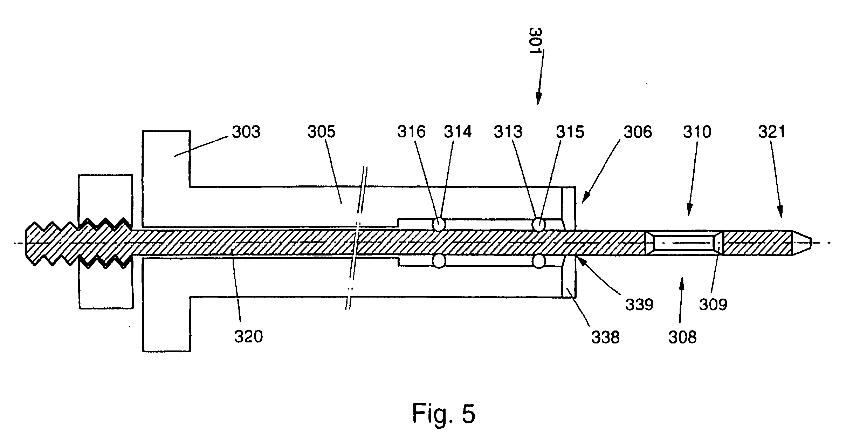

Fig. 5 shows a fifth example not being an embodiment of a specimen holder. In this example not being an embodiment the specimen holder 301 comprises a tubular bar element 305 fixedly connected with a foot 303. Mounted slidably within the bar element 305 is a drawer element 320 comprising, adjacent a first end 321 thereof, a bore 308 extending transversely to the longitudinal direction, with specimen-receiving means 309. Within the tubular bar element 305, a first seal 315 is accommodated in a first circular groove 313, and, spaced therefrom, a second seal 316 in a second circular groove 314. The distance between the two grooves is such that the specimen-receiving means 309 can be accommodated between the two seals, in such a manner that a specimen 310 received therein is closed off from the environment in that first position in airtight and moisture-proof manner.

The bar element 305 comprises, adjacent the free end 306 thereof, a closing plate 338 with a central opening 339 forming a sliding fit for the drawer 320. As a result, the drawer 320 can only move in the longitudinal direction and possibly rotate about the longitudinal axis, not transversely to it, and it is supported by direct contact with the closing plate 338 and the inside of the bar element 305, without intermediacy of the seals 315, 316.

Fig. 6 shows a cross section of a part of a specimen holder 1 with an alternative example not being an embodiment of the specimen-receiving means, on a larger scale. For simplicity, this example not being an embodiment is only discussed with reference to the specimen holder according to Fig. 2, but it can naturally be used in other specimen holders as well.

In the bar element 5, the bore 8 accommodates a ringshaped receiving member 11 capable of pivoting about a pivot 60 extending transversely to the longitudinal direction of the bar element 5 and transversely to the direction of the bore 8. The pivot 60 is bearing-mounted at both ends in the bar element 5. On the first side of the bore 8, proximal to the free end 6 of the bar element, a leaf spring 61 is confined, having its free end bearing on an underside of the receiving member 11, in such a manner that this receiving member is biassed into a pivoted position. Further, on the first side a forked pivoting arm 62 is bearing-mounted in the bar element 5 for pivotal motion about a pivot 64, a first finger 63 of the pivoting arm 62 abutting against the side of the receiving member 11. From the relevant side of the receiving member 11 extends a pawl 68, approximately parallel to the axis of rotation 60. The pawl is slidably mounted in a corresponding slot 68 provided in the first finger 63. The second finger 65 extends obliquely upwards to a point adjacent or above the edge of the bore 8. The pivoting arm 62 can swivel between a first position, wherein the receiving member 11 extends approximately horizontally, and a second position, wherein the receiving member is swivelled out of the horizontal plane. Fig. 6 shows the second position.

With the pivoting arm 62 in the first position, the upper end 66 of the second finger 65 is approximately level with the outer surface of the bar element 5, and with the receiving member 11 in the second position the upper end 66 extends outside the circumference of the bar element 5. The upper end 66 of the second finger is preferably rounded off or bevelled.

The screen 17 is provided with an opening at the top and at the bottom. At least the upper opening 32 has a bevelled longitudinal edge 67 on the side proximal to the bore, which longitudinal edge 67 can come into contact with the upper end 66 of the second finger 65.

The specimen-receiving means 9 and specimen holder 1 according to Fig. 6 can be used as follows.

The specimen 10 is fixed in the receiving member 11 by means of a screwable clamping ring 12 in the manner generally described above. Then the screen 17 is brought into the first position, whereby the second finger 65 is pressed downwards and the receiving member 11 with the specimen 10 is pivoted into the first position by displacement of the pawl 68 in the slot 69. After placement of the specimen holder 1 adjacent the microscope, the screen can be moved to the second position, so that the specimen 10 can be viewed. In doing so, the tilt of the receiving member 11 can be defined by the extent of the displacement of the screen 17, since during displacement of the screen 17 the upper end 66 of the second finger 65 contacts the bevelled longitudinal edge 67 of the opening 32. Upon displacement of the screen, the upper end will rise slowly along the bevel 67, so that the pivoting arm 62 too will pivot further in the direction of the second position.

Thus the position of the specimen can be accurately set and adjusted during use. Many variants are possible. For instance, different parts of the examples not being embodiments shown can be interchanged. The specimen-receiving means can be adapted for mounting several specimens simultaneously, and facilities may be incorporated, for instance, for rotating the specimen about a longitudinal axis and/or a transverse axis. Further, different examples not being embodiments of tilting mechanisms may be incorporated, which may or may not be externally operable. For the purpose of displacing the screen or drawer, other, for instance motor-driven, means may be arranged. Further, means may be included for conditioning the specimen, such as heating and cooling means as well as, for instance, means for producing a vacuum around the specimen.

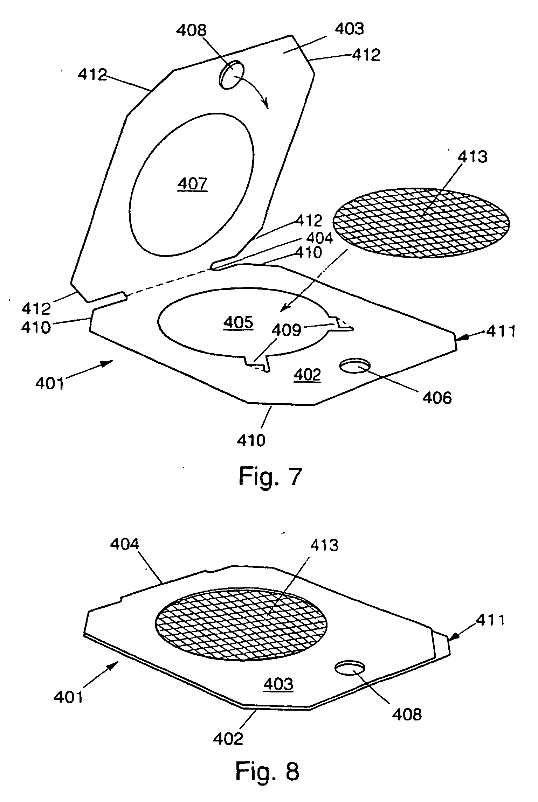

Hereinafter, aspects of the invention as claimed will be elucidated with reference to Figs. 7-10.

Fig. 7 shows a specimen carrier 401 in unfolded position. The specimen carrier 401 is formed from sheet material, such as for instance molybdenum film, but may also be made from different material. The specimen carrier 401 consists of two locking parts 402, 403 substantially identical in shape, extending on opposite sides of a folding line 404. In the condition shown in Fig. 7, the first locking part 402 has its back disposed flat on a surface, and the second locking part 403 is swung in upward direction.

The first locking part 402 is provided with a first approximately circular opening 405 located adjacent the folding line 404, and with a second approximately circular opening 406 located adjacent the side remote from the folding line 404, the second opening 406 being considerably smaller than the first opening 405. Adjacent the folding line 404 the second locking part 403 is provided with a third opening 407 corresponding substantially with the first opening 405, and adjacent the side remote from the folding line the second locking part 403 is provided with a projection 408 receivable in the second opening 406 with a clamping fit. The first opening 405 comprises two recesses 409 provided asymmetrically relative to the centre. As a result, tabs are formed which, when slightly bent, facilitate a proper positioning of the specimen 413.

The first locking part 402 is substantially rectangular and has three equal bevelled corners 410. The fourth corner 411, which is not situated on the side of the folding line 404, is bevelled to a lesser extent. The second locking part 403 has four bevelled corners 412. In the closed position of the specimen carrier 401, as shown in Fig. 8, the fourth corner 411 of the first locking part 402 accordingly extends outside the contour of the second locking part 403. This corner facilitates opening the specimen carrier. The folding line 404 is shorter than the width of the locking parts 402, 403, which renders it relatively simple to fold up the specimen carrier. The specimen carrier is, for instance, 3.5 mm wide and 5 mm long; the sheet material is, for instance, 0.05 mm thick. These dimensions are given here as an indication of the measurements of the embodiment shown.

The specimen 413 is disk-shaped and very thin. It has a surface slightly greater than that of the first 405 and third opening 407. As a result, the specimen can be placed by a peripheral edge thereof on the first locking part 402 around the first opening 405. Then the second locking part 403 can be folded over the specimen 413, in such a manner that the projection 408 is received in the second opening 406 with a clamping fit. The specimen 413 is thereby clamped between the first 402 and the second locking part 403. The specimen 413 can be seen from both sides of the specimen carrier 401 through the first opening 405 and the third opening 407, respectively. To protect the specimen 413, the specimen carrier 401, together with the specimen 413, can be placed in a conditioned space, for instance an airtight and moisture-proof cabinet, or the specimen carrier can, for instance, be stored in an airtight and moisture-proof outer envelope.

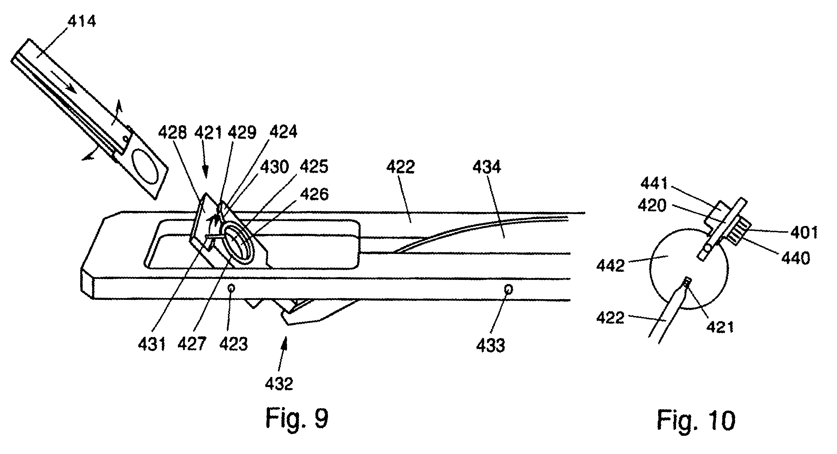

The specimen carrier 401 can be picked up by a manipulator 414 without the specimen 413 itself being touched in the process. The manipulator can be a manipulator such as a movable arm 420 shown in Fig. 10, but may, for instance, also be tongs or tweezers. The specimen carrier 401 can be inserted into specimen-receiving means 421 in a specimen holder 422. Fig. 9 shows the free end of a suitable specimen holder.

The specimen-receiving means 421 comprise a plate member 424 rotatable about an axis of rotation 423 and comprising a through bore 425 extending transversely to the axis of rotation 423. The bore 425 is provided with an at least partly circular shoulder 426, the part of the bore 425 located above the shoulder 426 being provided with internal screw thread. A threaded ring 427 is screwed into the bore above the shoulder 426. Provided at the front of plate member 424 is a lowered portion 428. Provided in plate member 424 and extending from the lowered portion is a slot, with shoulder 426 and the lowered portion 428 forming part of the bottom surface of the slot. The dimensions of the slot are such that the specimen carrier 401 fits into it, while the specimen 413 is visible through bore 425 and threaded ring 427. Provided above this slot, at the front, is an opening 429 whose walls extend approximately radially from bore 425 to the front of plate member 424. Extending between the walls 430 is an operating arm 431 which is connected on one side, for instance rigidly or via a screw connection, with the threaded ring 427 and on the other side extends above the lowered portion 428 outside the walls 430.

By means of the operating arm 431, the threaded ring 427 is movable between a free position and a clamping position. In the free position, the distance between the underside of the threaded ring 427 and the upper side of the shoulder 426 is greater than the thickness of the specimen holder 401 with the specimen 413 received therein; in the clamped position it is smaller. In the free position, the operating arm 431 abuts against one of the walls 430; in the clamped position, substantially against the other wall 430. As a result, the threaded ring 427 can traverse only a limited turn, for instance 90° or less, and cannot come clear of the plate member without prior removal of the operating arm. As a result, the threaded ring cannot be lost and it can be moved fast and uniformly between the free position and the clamping position.

On its side remote from the lowered portion 428, plate member 424 is pressed against tilting mechanism 432 by a spring. By means of the tilting mechanism 432, which comprises, for instance, a pivoting arm 434 tiltable about a second axis of rotation 433, the plate member 424 can be pivoted about the first axis of rotation 423 between two extreme positions. The tilting mechanism can be operated remote from the plate member 424 and preferably outside the electron microscope.

The specimen holder 422 and specimen carrier 401 can be used as follows.

The threaded ring 427 is brought into the free position, for instance by pressing against the operating arm 431 by means of the manipulator 414, 420. By means of the manipulator 414, 420, the specimen carrier 401 is then gripped adjacent a side remote from the opening 405, 407 and moved in the direction of the specimen-receiving means 421. It is advantageous here when, using a positioning block 440, a series of specimen carriers 401 are arranged in fixed positions (Fig. 10) within a conditioned space 441 communicating with a conditioned space 442 of the electron microscope. Each specimen carrier 401 can then be simply engaged, even (semi)automatically.

The end of the specimen carrier 401 remote from the manipulator 414, 420 is contacted with the lowered portion 428 and moved in the direction of the bore 425. The bevelled corners 410, 411, 412 guide the specimen carrier into the slot.

In the bore 425, the specimen carrier 401 is accommodated with some clearance between the shoulder 426 and the threaded ring 427, in such a manner that at least the portion of the specimen that is visible through the first 405 and the third opening 407 is visible within the bore 425 through the threaded ring 427. The specimen carrier 401 is then released and by means of the manipulator 414, 420 the operating arm is operated and the threaded ring is pressed to a maximum extent in the direction of the clamping position. Accordingly, the specimen carrier 401 with the specimen 413 is thereby fixed in the specimen-receiving means 421, in such a manner that the specimen 413 is visible from two sides of the specimen holder 422. If necessary, the specimen holder 422 can then be moved into a position where the specimen 413 can be viewed by means of the microscope.

After analysis of the specimen 413, the threaded ring 427 is screwed back into the free position by means of the manipulator, whereafter the specimen carrier 401 is removed from the specimen holder by means of the manipulator 414, 420 and is re-placed in the positioning block 440. Then a second or further specimen carrier can be taken from the positioning block 440 and be placed in the specimen-receiving means in the above-described manner.

During the analysis of the specimen, the position of the specimen relative to the electron microscope can be adjusted, in the embodiment shown in Figures 7 and 8, by movement of the specimen holder 422 and the tilting mechanism 432. Also possible, however, are designs which do not include a tilting mechanism and designs in which the movements are obtained in other known ways. It is possible to use, for instance, any one of the specimen holders 1, 101, 201, 301 described hereinabove. The invention as claimed is not in any way limited to the devices shown and described in the specification and the drawings. Many modifications are possible. For instance, the specimen carrier as claimed may be of different design. Further, the specimen carrier as claimed can naturally have a different shape than a rectangular shape, depending on, for instance, the specimen holder to be used. The specimen-receiving means may, for instance, also be designed as a drawer or be provided with a clamping plate hinged to a ground plate, between which the specimen carrier can be clamped. Further, a number of specimen carriers may be accommodated simultaneously in a specimen holder, allowing any one of the specimens to be viewed, as desired. The scope of the invention is defined by the appended claims.

## Claims

1. A device for mounting a specimen in an electron microscope, equipped with a specimen holder which comprises specimen-receiving means and is arranged to be at least partly received in an electron microscope, wherein at least one specimen carrier is provided which can contain a specimen in a position wherein the specimen is at least partly visible from the outside of the specimen carrier from at least two opposite sides of said carrier, the or each specimen carrier being receivable in the specimen receiving means, wherein the specimen carrier is made from sheet material, **characterized in that** the specimen carrier is folded from a sheet part and is provided with a folding line, the specimen being clampable between two locking parts of the sheet part extending on opposite sides of the folding line.

2. A device according to claim 1, **characterized in that** each locking part is provided with an opening through which during use the specimen can be seen.

3. A device according to claim 1 or 2, **characterized in that** the sheet material is made from film-shaped material.

4. A device according to claim 3, **characterized in that** the film-shaped material is molybdenum film.

5. A device according to any one of claims 1-4, **characterized in that** the specimen-receiving means comprise a bore in the specimen holder, which is open on two sides and is provided with a shoulder and at least partly with internal screw thread, a threaded ring being provided with external screw thread which is screwable into bore and by means of which the specimen carrier can be clamped against the shoulder in the bore.

6. A device according to claim 5, **characterized in that** the threaded ring is provided with an operating arm extending partly outside the holder during use, while the threaded ring needs to be turned through less than 360° for fixing and releasing the specimen carrier.

7. A device according to claim 5 or 6, **characterized in that** the specimen carrier is slidable from one side between a threaded ring at least partly screwed into the bore and the shoulder.

8. A device according to any one of claims 1-7, **characterized in that** the electron microscope is provided with a space closed off from the environment at least in airtight and moisture-proof manner, in which extend the specimen-receiving means, a series of specimen carriers being arranged in which a series of specimens are accommodated, with means being provided for manipulating at least the specimen carriers and the specimen-receiving means within the space, the arrangement being such that the specimen carriers and hence the specimens can be exchanged for analysis in the electron microscope without the specimen holder having to be removed from the electron microscope for that purpose.

9. A device according to claim 8, **characterized in that** the specimen carriers are arranged in a storage space located outside the electron microscope, which communicated with the closed space of the electron microscope.

10. A specimen carrier for use in a device according to any one of the preceding claims, **characterized in that** the specimen carrier is folded from a sheet part provided with a folding line, a specimen being clampable between two locking parts of the sheet part extending on opposite sides of the folding line.

## Patentansprüche

1. Vorrichtung zum Anbringen einer Probe in einem Elektronenmikroskop, das mit einer Probenhalterung versehen ist, welche Probenaufnahmeeinrichtungen aufweist und derart angeordnet ist, dass sie wenigstens teilweise in einem Elektronenmikroskop aufgenommen wird, worin wenigstens ein Probenträger vorgesehen ist, der eine Probe in einer Position enthalten kann, in der sie wenigstens teilweise von der Außenseite des Probenträgers von wenigstens zwei entgegengesetzten Seiten des Trägers sichtbar ist, wobei der oder jeder Probenträger in den Probenaufnahmeeinrichtungen aufnehmbar ist, worin der Probenträger aus einem Blattmaterial hergestellt ist,
**dadurch gekennzeichnet, dass**
die Probenhalterung aus einem Blattteil gefaltet und mit einer Faltlinie versehen ist, wobei die Probe zwischen zwei Verschlussteilen des Blattteils klemmbar ist, die sich an entgegengesetzten Seiten der Faltlinie erstrecken.

2. Vorrichtung nach Anspruch 1, **dadurch gekennzeichnet, dass** jedes Verschlussteil mit einer Öffnung versehen ist, durch welche die Probe während der Benutzung betrachtet werden kann.

3. Vorrichtung nach Anspruch 1 oder 2, **dadurch gekennzeichnet, dass** das Blattmaterial aus einem filmförmigen Material hergestellt ist.

4. Vorrichtung nach Anspruch 3, **dadurch gekennzeichnet, dass** das filmförmige Material ein Molybdänfilm ist.

5. Vorrichtung nach einem der Ansprüche 1 bis 4, **dadurch gekennzeichnet, dass** die Probenaufnahmeeinrichtungen in der Probenhalterung eine Bohrung aufweisen, die an zwei Seiten offen und mit einem Absatz und wenigstens teilweise mit einem Innengewinde versehen ist, wobei ein Gewindering mit Außengewinde versehen ist, der in die Bohrung schraubbar ist und durch den der Probenträger gegen den Absatz in der Bohrung klemmbar ist.

6. Vorrichtung nach Anspruch 5, **dadurch gekennzeichnet, dass** der Gewindering mit einem Betätigungsarm versehen ist, der sich während der Benutzung teilweise außerhalb der Halterung erstreckt, während der Gewindering bis weniger als 360° gedreht werden muss, um den Probenträger zu befestigen und zu lösen.

7. Vorrichtung nach Anspruch 5 oder 6, **dadurch gekennzeichnet, dass** der Probenträger von einer Seite zwischen einem Gewindering, der wenigstens teilweise in die Bohrung geschraubt ist, und dem Absatz verschiebbar ist.

8. Vorrichtung nach einem der Ansprüche 1 bis 7, **dadurch gekennzeichnet, dass** das Elektronenmikroskop mit einem Raum versehen ist, der von der Umgebung wenigstens luft- und feuchtigkeitsdicht verschlossen ist und in den sich die Probenaufnahmeeinrichtungen erstrecken, wobei eine Reihe von Probenträgern, in denen eine Reihe von Proben untergebracht ist, mit Einrichtungen angeordnet ist, die vorgesehen sind, um zumindest die Probenträger und die Probenaufnahmeeinrichtungen in dem Raum zu bedienen, wobei die Anordnung derart ist, dass die Probenträger und daher die Proben für eine Analyse in dem Elektronenmikroskop ausgetauscht werden können, ohne dass die Probenhalterung dafür von dem Elektronenmikroskop entfernt werden muss.

9. Vorrichtung nach Anspruch 8, **dadurch gekennzeichnet, dass** die Probenträger in einem Speicherraum angeordnet sind, der außerhalb des Elektronenmikroskops angeordnet ist und mit dem geschlossenen Raum des Elektronenmikroskops in Verbindung steht.

10. Probenträger zur Verwendung in einer Vorrichtung nach einem der vorhergehenden Ansprüche, **dadurch gekennzeichnet, dass** der Probenträger aus einem Blattteil gefaltet ist, das mit einer Faltlinie versehen ist, wobei eine Probe zwischen zwei Verschlussteilen des Blattteils klemmbar ist, die sich an entgegengesetzten Seiten der Faltlinie erstrecken.

## Revendications

1. Dispositif pour placer un échantillon dans un microscope électronique, équipé d'un porte-échantillon qui comprend des moyens de réception d'échantillon et qui est disposé pour être dans lequel au moins en partie reçu dans un microscope électronique, au moins un support d'échantillon est prévu, qui peut contenir un échantillon dans une position dans laquelle l'échantillon est visible au moins partiellement depuis l'extérieur du support d'échantillon depuis au moins deux côtés opposés dudit support, le ou chaque support d'échantillon étant adapté à être reçu dans les moyens de réception d'échantillon, le support d'échantillon étant réalisé à partir d'un matériau en feuille, **caractérisé en ce que** le support d'échantillon est plié à partir d'une partie en feuille et est fourni avec une ligne de pliage, l'échantillon étant adapté à être maintenu entre deux parties de blocage de la partie en feuille s'étendant de part et d'autre de la ligne de pliage.

2. Dispositif selon la revendication 1 **caractérisé en ce que** chaque partie de blocage est munie d'une ouverture à travers laquelle l'échantillon peut être vu pendant l'utilisation.

3. Dispositif selon la revendication 1 ou 2, **caractérisé en ce que** le matériau en feuille est réalisé à partir d'un matériau en forme de film.

4. Dispositif selon la revendication 3, **caractérisé en ce que** le matériau en forme de film est un film de molybdène.

5. Dispositif selon l'une quelconque des revendications 1 à 4, **caractérisé en ce que** les moyens de réception d'échantillon comprennent un trou dans le porte-échantillon, qui est ouvert sur les deux côtés et qui est muni d'un épaulement et au moins partiellement d'un filet interne, un anneau fileté muni d'un filet externe étant adapté à être vissé dans le trou, le support d'échantillon étant monté contre l'épaulement dans le trou au moyen dudit anneau.

6. Dispositif selon la revendication 5, **caractérisé en ce que** l'anneau fileté est muni d'un bras de commande s'étendant partiellement hors du porte-échantillon pendant l'utilisation tandis que l'anneau fileté nécessite d'être tourné d'un angle inférieur à 360° pour la fixation et la libération du support d'échantillon.

7. Dispositif selon la revendication 5 ou 6, **caractérisé en ce que** le support d'échantillon est adapté à glisser depuis un côté entre l'anneau fileté au moins partiellement vissé dans le trou et l'épaulement.

8. Dispositif selon l'une quelconque des revendications 1 à 7, **caractérisé en ce que** le microscope électronique est muni d'un espace isolé de l'environnement, étanche au moins à l'air et à l'humidité, dans lequel s'étendent les moyens de réception d'échantillon, une série de supports d'échantillon étant disposée avec une série d'échantillons logés dans lesdits supports avec des moyens prévus pour manipuler au moins les supports d'échantillon et les moyens de réception d'échantillon dans l'espace, la disposition étant telle que les supports d'échantillon et donc les échantillons peuvent être échangés pour analyse dans le microscope électronique sans que le porte-échantillon ait à être retiré du microscope électronique à cet effet.

9. Dispositif selon la revendication 8, **caractérisé en ce que** les supports d'échantillon sont disposés dans un espace de stockage situé à l'extérieur du microscope électronique qui communique avec l'espace clos du microscope électronique.

10. Support d'échantillon destiné à être utilisé dans un dispositif selon l'une quelconque des revendications précédentes, **caractérisé en ce que** le support d'échantillon est plié à partir d'une partie en feuille munie d'une ligne de pliage, un échantillon étant maintenu entre deux parties de blocage de la partie en feuille s'étendant de part et d'autre de la ligne de pliage.
